# EUROPÄISCHE PATENTSCHRIFT

(11) **EP 2 270 877 B1**
(45) Veröffentlichungstag und Bekanntmachung des Hinweises auf die Patenterteilung: **11.09.2013**
(21) Anmeldenummer: 10184975.0
(22) Anmeldetag: 26.06.1997
(51) Int. Cl.: H01L 33/48, C09K 11/77, H01L 33/50

(54) **Licht abstrahlendes Halbleiterbauelement mit Lumineszenzkonversionselement**
Light-emitting semiconductor device with luminescence conversion element
Dispositif semi-conducteur luminescent avec élément convertisseur de luminescence

(30) Priorität: 26.06.1996 DE 19625622; 20.09.1996 DE 19638667
(43) Veröffentlichungstag der Anmeldung: 05.01.2011
(62) Teilanmeldung aus: 04008348.7
(73) Patentinhaber: OSRAM Opto Semiconductors GmbH, 93055 Regensburg (DE)
(72) Erfinder: Schneider, Jürgen, 79117 Freiburg (DE); Schmidt, Ralf, 79279 Vörstetten (DE); Schlotter, Peter, 79112 Freiburg (DE); Reeh, Ulrike, 80995 München (DE); Höhn, Klaus, 91301 Forchheim (DE); Stath, Norbert, 93049 Regensburg (DE); Waitl, Günter, 93049 Regensburg (DE)
(74) Vertreter: Epping - Hermann - Fischer

(56) Entgegenhaltungen:
- EP-A1- 0 142 931
- EP-A1- 0 581 232
- EP-A2- 0 691 798
- DE-A1- 2 739 437
- JP-A- 4 137 570
- JP-A- 5 152 609
- JP-A- 7 193 281

## Beschreibung

Die Erfindung bezieht sich auf ein Licht abstrahlendes Halbleiterbauelement nach dem Oberbegriff des Patentanspruches 1.

Ein derartiges Halbleiterbauelement ist beispielsweise aus der Offenlegungsschrift DE 38 04 293 bekannt. Darin ist eine Anordnung mit einer Elektrolumineszenz- oder Laserdiode beschrieben, bei der das gesamte von der Diode abgestrahlte Emmissionsspektrum mittels eines mit einem fluoreszierenden, Licht wandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte. Abhängig von der Art des dem Kunststoff beigefügten Farbstoffes lassen sich mit ein und demselben Leuchtdiodentyp Leuchtdiodenanordnungen herstellen, die in unterschiedlichen Farben leuchten.

Aus DE-OS 2 347 289 ist eine Infrarot(IR)-Festkörperlampe bekannt, bei der an der Kante einer IR-Diode Leuchtstoff-Material angebracht ist, das die dort abgestrahlte IR-Strahlung in sichtbares Licht umwandelt. Ziel dieser Maßnahme ist es, zu Kontrollzwecken einen möglichst geringen Teil der von der Diode abgegebenen IR-Strahlung bei gleichzeitig möglichst geringer Verminderung der Intensität der abgegebenen IR-Strahlung in sichtbares Licht umzuwandeln. Weiterhin ist aus der EP 486 052 eine Licht emittierende Diode bekannt, bei der zwischen dem Substrat und einer aktiven elektrolumineszierenden Schicht mindestens eine Halbleiter-Photolumineszenzschicht angeordnet ist, die das von der aktiven Schicht in Richtung Substrat ausgesandte Licht eines ersten Wellenlängenbereichs in Licht eines zweiten Wellenlängenbereichs umwandelt, so dass die Licht emittierende Diode insgesamt Licht verschiedener Wellenlängenbereiche aussendet.

In der EP-A-0 581 232 wird eine elektrolumineszente Lichtquelle mit einer Lumineszenzkonversionsschicht und eine Filterschicht beschrieben.

Aus der JP-A-4 137 570 ist zudem bekannt, zusätzlich Licht streuende Partikel in einer Lumineszenzkonversionsumhüllung vorzusehen und dadurch eine gleichmäßige Ausleuchtung zu erhalten.

In vielen potentiellen Anwendungsgebieten für Leuchtdioden, wie zum Beispiel bei Anzeigeelementen im Kfz-Armaturenbrett, Beleuchtung in Flugzeugen und Autos und bei vollfarbtauglichen LED-Displays, tritt verstärkt die Forderung nach Leuchtdiodenanordnungen auf, mit denen sich mischfarbiges Licht, insbesondere weißes Licht erzeugen lässt.

In JP-07 176 794-A ist eine weißes Licht aussendende planare Lichtquelle beschrieben, bei der an einer Stirnseite einer transparenten Platte zwei blaues Licht emittierende Dioden angeordnet sind, die Licht in die transparente Platte hinein aussenden. Die transparente Platte ist auf einer der beiden einander gegenüberliegenden Hauptflächen mit einer fluoreszierenden Substanz beschichtet, die Licht emittiert, wenn sie mit dem blauen Licht der Dioden angeregt wird. Das von der fluoreszierenden Substanz emittierte Licht hat eine andere Wellenlänge als das von den Dioden emittierte blaue Licht. Bei diesem bekannten Bauelement ist es besonders schwierig, die fluoreszierende Substanz in einer Art und Weise aufzubringen, dass die Lichtquelle homogenes weißes Licht abstrahlt. Darüber hinaus bereitet auch die Reproduzierbarkeit in der Massenfertigung große Probleme, weil schon geringe Schichtdickenschwankungen der fluoreszierenden Schicht, zum Beispiel aufgrund von Unebenheiten der Oberfläche der transparenten Platte, eine Änderung des Weißtones des abgestrahlten Lichtes hervorruft.

Der vorliegenden Erfindung liegt die Aufgabe zugrunde, ein Halbleiterbauelement der eingangs genannten Art zu entwickeln, das homogenes mischfarbiges Licht abstrahlt und das eine technisch einfache Massenfertigung mit weitestgehend reproduzierbarer Bauelementcharakteristik gewährleistet.

Diese Aufgabe wird durch ein Halbleiterbauelement nach Anspruch 1 gelöst. Vorteilhafte Weiterbildungen der Erfindung sind Gegenstand der Unteransprüche 2 bis 11. Der Unteranspruch 12 gibt eine bevorzugte Verwendungsmöglichkeit des erfindungsgemäßen Halbleiterbauelements an.

Erfindungsgemäß ist vorgesehen, dass der strahlungsemittierende Halbleiterkörper eine Schichtenfolge, insbesondere eine Schichtenfolge mit einer aktiven Halbleiterschicht aus GaₓIn₁₋ₓN oder GaₓAl₁₋ₓN aufweist, die im Betrieb des Halbleiterbauelements eine elektromagnetische Strahlung eines ersten Wellenlängenbereiches aus dem ultravioletten, blauen und/oder grünen Spektralbereich aussendet. Das Lumineszenzkonversionselement wandelt einen Teil der aus dem ersten Wellenlängenbereich stammenden Strahlung in Strahlung eines zweiten Wellenlängenbereiches um, derart, dass das Halbleiterbauelement Mischstrahlung, insbesondere mischfarbiges Licht, bestehend aus Strahlung des ersten Wellenlängenbereiches und Strahlung des zweiten Wellenlängenbereiches, aussendet. Das heißt beispielsweise, dass das Lumineszenzkonversionselement einen Teil der vom Halbleiterkörper ausgesandten Strahlung bevorzugt nur über einen spektralen Teilbereich des ersten Wellenlängenbereichs spektral selektiv absorbiert und im längerwelligen Bereich (im zweiten Wellenlängenbereich) emittiert. Dabei weist die von dem Halbleiterkörper ausgesandte Strahlung bei einer Wellenlänge λ ≤ 520 nm ein relatives Intensitätsmaximum auf und liegt der von dem Lumineszenzkonversionselement spektral selektiv absorbierte Wellenlängenbereich außerhalb dieses Intensitätsmaximums.

Ebenso wird vorteilhafterweise mit der Erfindung auch eine Anzahl (einer oder mehrerer) von aus dem ersten Wellenlängenbereich stammenden ersten spektralen Teilbereichen in mehrere zweite Wellenlängenbereiche umgewandelt. Dadurch ist es vorteilhafterweise möglich, vielfältige Farbmischungen und Farbtemperaturen zu erzeugen.

Das erfindungsgemäße Halbleiterbauelement hat den besonderen Vorteil, dass das über Lumineszenzkonversion erzeugte Wellenlängenspektrum und damit die Farbe des abgestrahlten Lichtes nicht von der Höhe der Betriebsstromstärke durch den Halbleiterkörper abhängt. Dies hat insbesondere dann große Bedeutung, wenn die Umgebungstemperatur des Halbleiterbauelementes und folglich bekanntermaßen auch die Betriebsstromstärke stark schwankt. Besonders Leuchtdioden mit einem Halbleiterkörper auf der Basis von GaN sind diesbezüglich sehr empfindlich.

Außerdem benötigt das erfindungsgemäße Halbleiterbauelement nur eine einzige Ansteuerspannung und damit auch nur eine einzige Ansteuerschaltungsanordnung, wodurch der Bauteileaufwand für die Ansteuerschaltung des Halbleiterbauelements sehr gering gehalten werden kann.

Bei einer Ausführungsform der Erfindung sind als Lumineszenzkonversionselement über oder auf dem Halbleiterkörper teiltransparente, das heißt für die von dem Strahlung aussendenden Halbleiterkörper ausgesandte Strahlung teilweise transparente Lumineszenzkonversionsschichten vorgesehen. Um eine einheitliche Farbe des abstrahlten Lichtes sicherzustellen, sind vorteilhafterweise die Lumineszenzkonversionsschicht derart ausgebildet, dass sie durchweg eine konstante Dicke aufweisen. Dies hat den besonderen Vorteil, dass die Weglänge des von dem Halbleiterkörper abgestrahlten Lichtes durch die Lumineszenzkonversionsschicht hindurch für alle Strahlungsrichtungen nahezu konstant ist. Dadurch kann erreicht werden, dass das Halbleiterbauelement in alle Richtungen Licht derselben Farbe abstrahlt. Ein weiterer besonderer Vorteil eines erfindungsgemäßen Halbleiterbauelements gemäß dieser Weiterbildung besteht darin, dass auf einfache Weise eine hohe Reproduzierbarkeit erzielt werden kann, was für eine effiziente Massenfertigung von wesentlicher Bedeutung ist. Als Lumineszenzkonversionsschichten können beispielsweise mit Leuchtstoff versetzte Lack- oder Harzschichten vorgesehen sein.

Bei vorteilhaften Ausführungsformen des erfindungsgemäßen Halbleiterbauelements bestehen die Lumineszenzkonversionsschichen aus einem transparenten Material, zum Beispiel Kunststoff, bevorzugt Epoxidharz, das mit mindestens einem Leuchtstoff versehen ist (Beispiele für bevorzugte Kunststoffe und Leuchtstoffe finden sich weiter unten). Auf diese Weise lassen sich Lumineszenzkonversionselemente besonders kostengünstig herstellen. Die dazu notwendigen Verfahrensschritte sind nämlich ohne großen Aufwand in herkömmliche Produktionslinien für Leuchtdioden integrierbar.

Bei einer besonders bevorzugten Weiterbildung der Erfindung ist vorgesehen, dass der oder die zweiten Wellenlängenbereiche im Wesentlichen größere Wellenlängen aufweisen als der erste Wellenlängenbereich.

Insbesondere ist vorgesehen, dass ein zweiter spektraler Teilbereich des ersten Wellenlängenbereiches und ein zweiter Wellenlängenbereich zueinander komplementär sind. Auf diese Weise kann aus einer einzigen farbigen Lichtquelle, insbesondere einer Leuchtdiode mit einem einzigen blaues Licht abstrahlenden Halbleiterkörper, mischfarbiges, insbesondere weißes Licht erzeugt werden. Um zum Beispiel mit einem blaues Licht aussendenden Halbleiterkörper weißes Licht zu erzeugen, wird ein Teil der von dem Halbleiterkörper ausgesandten Strahlung aus dem blauen Spektralbereich in den zu Blau komplementärfarbigen gelben Spektralbereich konvertiert. Die Farbtemperatur oder Farbort des weißen Lichtes kann dabei durch geeignete Wahl des Lumineszenzkonversionselementes, insbesondere durch eine geeignete Wahl des Leuchtstoffes, dessen Partikelgröße und dessen Konzentration, variiert werden. Darüber hinaus bieten diese Anordnungen vorteilhafterweise auch die Möglichkeit, Leuchtstoffmischungen einzusetzen, wodurch sich vorteilhafterweise der gewünschte Farbton sehr genau einstellen lässt. Ebenso können Lumineszenzkonversionselemente inhomogen ausgestaltet sein, zum Beispiel mittels einer inhomogenen Leuchtstoffverteilung. Unterschiedliche Weglängen des Lichtes durch das Lumineszenzkonversionselement können dadurch vorteilhafterweise kompensiert werden.

Bei einer weiteren bevorzugten Ausführungsform des erfindungsgemäßen Halbleiterbauelements weist das Lumineszenzkonversionselement oder ein anderer Bestandteil einer Bauteilumhüllung zur Farbanpassung einen oder mehrere Farbstoffe auf, die keine Wellenlängenkonversion bewirken. Hierzu können die für die Herstellung von herkömmlichen Leuchtdioden verwendeten Farbstoffe wie zum Beispiel Azo-, Anthrachinon- oder Perinon-Farbstoffe eingesetzt werden.

Zum Schutz des Lumineszenzkonversionselements vor einer zu hohen Strahlenbelastung ist bei einer vorteilhaften Weiterbildung beziehungsweise bei den oben genannten bevorzugten Ausführungsformen des erfindungsgemäßen Halbleiterbauelements zumindest ein Teil der Oberfläche des Halbleiterkörpers von einer ersten, zum Beispiel aus einem Kunststoff bestehenden transparenten Hülle umgeben, auf der die Lumineszenzkonversionsschicht aufgebracht ist. Dadurch wird die Strahlungsdichte im Lumineszenzkonversionselement und somit dessen Strahlungsbelastung verringert, was sich je nach verwendeten Materialien positiv auf die Lebensdauer des Lumineszenzkonversionselementes auswirkt.

Bei einer besonders bevorzugten Ausgestaltung der Erfindung sowie der oben genannten Ausführungsformen ist ein strahlungsemittierender Halbleiterkörper verwendet, bei dem das ausgesandte Strahlungsspektrum bei einer Wellenlänge zwischen 420 nm und 460 nm, insbesondere bei 430 nm (zum Beispiel Halbleiterkörper auf der Basis von GaₓAl₁₋ₓN) oder 450 nm (zum Beispiel Halbleiterkörper auf der Basis von GaₓIn₁₋ₓN) ein Intensitätsmaximum aufweist. Mit einem derartigen erfindungsgemäßen Halbleiterbauelement lassen sich vorteilhafterweise nahezu sämtliche Farben und Mischfarben der CIE-Farbtafel erzeugen. Der strahlungsemittierende Halbleiterkörper kann hierbei, wie oben angegeben, im Wesentlichen aus elektrolumineszierendem Halbleitermaterial aber auch aus einem anderen elektrolumineszierenden Material, wie beispielsweise Polymermaterial, bestehen.

Bei einer weiteren besonders bevorzugten Weiterbildung der Erfindung und deren Ausführungsformen ist die Lumineszenzkonversionsumhüllung beziehungsweise die Lumineszenzkonversionsschicht aus einem Lack oder aus einem Kunststoff hergestellt, beispielsweise aus einem für die Umhüllung optoelektronischer Bauelemente eingesetzten Silikon-, Thermoplast- oder Duroplastmaterial (Epoxid- und Acrylatharze). Des Weiteren können zum Beispiel aus Thermoplastmaterialien gefertigte Abdeckelemente als Lumineszenzkonversionsumhüllung eingesetzt sein. Sämtliche oben genannten Materialien lassen sich auf einfache Weise mit einem oder mehreren Leuchtstoffen versetzen.

Besonders einfach lässt sich ein erfindungsgemäßes Halbleiterbauelement dann realisieren, wenn der Halbleiterkörper in einer Ausnehmung eines gegebenenfalls vorgefertigten Gehäuses angeordnet ist und die Ausnehmung mit einem die Lumineszenzkonversionsschicht aufweisenden Abdeckelement versehen ist. Ein derartiges Halbleiterbauelement lässt sich in großer Stückzahl in herkömmlichen Produktionslinien herstellen. Hierzu muss lediglich nach der Montage des Halbleiterkörpers in das Gehäuse das Abdeckelement, beispielsweise eine Lack- oder Gießharzschicht oder eine vorgefertigtes Abdeckplatte aus Thermoplastmaterial, auf das Gehäuse aufgebracht werden. Optional kann die Ausnehmung des Gehäuses mit einem transparenten Material, beispielsweise einem transparenten Kunststoff, gefüllt sein, das insbesondere die Wellenlänge des von dem Halbleiterkörper ausgesandten Lichtes nicht verändert oder aber, falls gewünscht, bereits lumineszenzkonvertierend ausgebildet sein kann.

Bei einer aufgrund besonders einfacher Realisierbarkeit besonders bevorzugten Weiterbildung des erfindungsgemäßen Halbleiterbauelements ist der Halbleiterkörper in einer Ausnehmung eines gegebenenfalls vorgefertigten eventuell bereits mit einem Leadframe versehenen Gehäuse angeordnet und ist die Ausnehmung mit einem zumindest teiltransparenten Gießharz gefüllt, dem der Leuchtstoff bereits vor dem Ausgießen der Ausnehmung zugefügt ist. Das Lumineszenzkonversionselement ist hier somit von dem mit Leuchtstoff versehenen Verguss des Halbleiterkörpers versehen.

Ein besonders bevorzugtes Material zur Herstellung des Lumineszenzkonversionselements ist Epoxidharz, dem ein oder mehrere Leuchtstoffe zugesetzt sind. Anstelle von Epoxidharz kann aber auch Polymethylmetacrylat (PMMA) verwendet sein.

PMMA lässt sich auf einfache Weise mit organischen Farbstoffmolekülen versetzen. Zur Herstellung von grün, gelb und rot leuchtenden erfindungsgemäßen Halbleiterbauelementen können zum Beispiel Farbstoffmoleküle auf Perylen-Basis verwendet sein. Im UV, im Sichtbaren oder im Infraroten leuchtende Halbleiterbauelemente können auch durch Beimischung von 4f-metallorganischen Verbindungen hergestellt werden. Insbesondere können rot leuchtende erfindungsgemäße Halbleiterbauelemente zum Beispiel durch Beimischung von auf Eu³⁺ basierenden metallorganischen Chelaten (λ ≈ 620 nm) realisiert werden. Infrarot strahlende erfindungsgemäße Halbleiterbauelemente, insbesondere mit blaues Licht aussendenden Halbleiterkörpern, können mittels Beimischung von 4f-Chelaten oder von Ti³⁺-dotiertem Saphir hergestellt werden.

Ein weißes Licht abstrahlendes erfindungsgemäßes Halbleiterbauelement lässt sich vorteilhafterweise dadurch herstellen, dass der Leuchtstoff so gewählt wird, dass eine von dem Halbleiterkörper ausgesandte blaue Strahlung in komplementäre Wellenlängenbereiche, insbesondere Blau und Gelb, oder zu additiven Farbtripeln, zum Beispiel Blau, Grün und Rot umgewandelt wird. Hierbei wird das gelbe beziehungsweise das grüne und rote Licht über die Leuchtstoffe erzeugt. Der Farbton (Farbort in der CIE-Farbtafel) des dadurch erzeugten weißen Lichts kann dabei durch geeignete Wahl des/der Farbstoffes/e hinsichtlich Mischung und Konzentration variiert werden.

Geeignete organische Leuchtstoffe für ein weißes Licht abstrahlendes erfindungsgemäßes Halbleiterbauelement sind Perylen-Leuchtstoffe wie zum Beispiel BASF Lumogen F 083 für grüne Lumineszenz, BASF Lumogen F 240 für gelbe Lumineszenz und BASF Lumogen F 300 für rote Lumineszenz. Diese Farbstoffe lassen sich auf einfache Weise zum Beispiel transparentem Epoxidharz, zusetzen.

Eine bevorzugte Methode, mit einem blaues Licht abstrahlenden Halbleiterkörper ein grün leuchtendes Halbleiterbauelement herzustellen, besteht darin, für das Lumineszenzkonversionselement UO₂⁺⁺-substituiertes Borsilikatglas zu verwenden.

Bei einer weiteren bevorzugten Weiterbildung eines erfindungsgemäßen Halbleiterbauelements beziehungsweise der oben angegebenen vorteilhaften Ausführungsformen sind dem Lumineszenzkonversionselement oder einer anderen strahlungsdurchlässigen Komponente der Bauteilumhüllung zusätzlich Licht streuende Partikel, so genannte Diffusoren, zugesetzt. Hierdurch lässt sich vorteilhafterweise der Farbeindruck und die Abstrahlcharakteristik des Halbleiterbauelements optimieren.

Bei einer besonders vorteilhaften Ausführungsform des erfindungsgemäßen Halbleiterbauelements besteht das Lumineszenzkonversionselement zumindest teilweise aus einem transparenten Epoxidharz, das mit einem anorganischen Leuchtstoff versehen ist. Vorteilhafterweise lassen sich nämlich anorganische Leuchtstoffe auf einfache Weise in Epoxidharz einbinden. Ein besonders bevorzugter anorganischer Leuchtstoff zur Herstellung von weiß leuchtenden erfindungsgemäßen Halbleiterbauelementen ist der Phosphor YAG:Ce (Y₃Al₅O₁₂:Ce³⁺). Dieser lässt sich auf besonders einfache Weise in herkömmlich in der LED-Technik verwendeten transparenten Epoxidharzen mischen. Weiterhin als Leuchtstoffe denkbar sind weitere mit seltenen Erden dotierte Granate wie zum Beispiel Y₃Ga₅O₁₂:Ce³⁺, Y(Al,Ga)₅O₁₂:Ce³⁺ und Y(Al,Ga)₅O₁₂:Tb³⁺ sowie mit seltenen Erden dotierte Erdalkali-Sulfide wie zum Beispiel SrS:Ce³⁺,Na, SrS:Ce³⁺,Cl, SrS:CeCl₃, CaS:Ce³⁺ und SrSe:Ce³⁺.

Zur Erzeugung von verschiedenartig mischfarbigem Licht eignen sich darüber hinaus besonders die mit seltenen Erden dotierten Thiogallate wie zum Beispiel CaGa₂S₄:Ce³⁺ und SrGa₂S₄:Ce³⁺. Ebenso ist hierzu die Verwendung von mit seltenen Erden dotierten Aluminaten wie zum Beispiel YAlO₃:Ce³⁺, YGaO₃:Ce³⁺, Y(Al,Ga)O₃:Ce³⁺ und mit seltenen Erden dotierten Orthosilikaten M₂SiO₅:Ce³⁺ (M: Sc, Y, Sc) wie zum Beispiel Y₂SiO₅:Ce³⁺ denkbar. Bei allen Yttriumverbindungen kann das Yttrium im Prinzip auch durch Scandium oder Lanthan ersetzt werden.

Bei einer weiteren möglichen Ausführungsform des erfindungsgemäßen Halbleiterbauelements bestehen zumindest alle Licht durchstrahlten Komponenten der Umhüllung, das heißt auch die Lumineszenzkonversionsumhüllung beziehungsweise -schicht aus rein anorganischen Materialien. Das Lumineszenzkonversionselement besteht somit aus einem anorganischen Leuchtstoff, der in einem temperaturstabilen, transparenten oder teiltransparenten anorganischen Material eingebettet ist. Insbesondere besteht das Lumineszenzkonversionselement aus einem anorganischen Phosphor, der in ein vorteilhafterweise niedrig schmelzendes anorganisches Glas (zum Beispiel Silikatglas) eingebettet ist. Eine bevorzugte Herstellungsweise für eine derartige Lumineszenzkonversionsschicht ist die Sol-Gel-Technik, mit der die gesamte Lumineszenzkonversionsschicht, das heißt sowohl der anorganische Leuchtstoff als auch das Einbettmaterial in einem Arbeitsgang hergestellt werden kann.

Um die Durchmischung der von dem Halbleiterkörper ausgesandten Strahlung des ersten Wellenlängenbereiches mit der lumineszenzkonvertierten Strahlung des zweiten Wellenlängebereiches und damit die Farbhomogenität des abstrahlten Lichtes zu verbessern, ist bei einer vorteilhaften Ausgestaltung des erfindungsgemäßen Halbleiterbauelements der Lumineszenzumhüllung beziehungsweise der Lumineszenzkonversionsschicht und/oder einer anderen Komponente der Bauteilumhüllung zusätzlich ein im Blauen lumineszierender Farbstoff zugefügt, der eine so genannte Richtcharakteristik der von dem Halbleiterkörper abgestrahlten Strahlung abschwächt. Unter Richtcharakteristik ist zu verstehen, dass die von dem Halbleiterkörper ausgesandte Strahlung eine bevorzugte Abstrahlrichtung aufweist.

Bei einer bevorzugten Ausgestaltung des erfindungsgemäßen Halbleiterbauelements ist zum oben genannten Zweck der Durchmischung der ausgesandten Strahlung der anorganische Leuchtstoff in Pulverform verwendet, wobei sich die Leuchtstoffpartikel in dem sie umhüllenden Stoff (Matrix) nicht lösen. Außerdem weisen der anorganische Leuchtstoff und der ihn umhüllende Stoff voneinander verschiedene Brechungsindizes auf. Dies führt vorteilhafterweise dazu, dass abhängig von der Korngröße des Leuchtstoffes, ein Anteil des nicht vom Leuchtstoff absorbierten Lichtes gestreut wird. Dadurch ist die Richtcharakteristik der von dem Halbleiterkörper abgestrahlten Strahlung effizient geschwächt, so dass die nicht absorbierte Strahlung und die lumineszenzkonvertierte Strahlung homogen gemischt werden, was zu einem räumlich homogenen Farbeindruck führt.

Ein weißes Licht abstrahlendes erfindungsgemäßes Halbleiterbauelement lässt sich besonders bevorzugt dadurch realisieren, dass einem zur Herstellung der Lumineszenzkonversionsumhüllung oder -schicht verwendeten Epoxidharz der anorganische Leuchtstoff YAG:Ce (Y₃Al₅O₁₂:Ce³⁺) beigemischt ist. Ein Teil einer von dem Halbleiterkörper ausgesandten blauen Strahlung wird von dem anorganischen Leuchtstoff Y₃Al₅O₁₂:Ce³⁺ in den gelben Spektralbereich und somit in einen zur Farbe Blau komplementärfarbigen Wellenlängenbereich verschoben. Der Farbton (Farbort in der CIE-Farbtafel) des weißen Lichts kann dabei durch geeignete Wahl der Farbstoffmischung und -konzentration variiert werden.

Der anorganische Leuchtstoff YAG:Ce hat unter anderem den besonderen Vorteil, dass es sich hierbei um nicht lösliche Farbpigmente (Partikelgröße im Bereich von 10 µm) mit einem Brechungsindex von zirka 1,84 handelt. Dadurch tritt neben der Wellenlängenkonversion noch ein Streueffekt auf, der zu einer guten Vermischung von blauer Diodenstrahlung und gelber Konverterstrahlung führt.

Bei einer weiteren bevorzugten Weiterbildung eines erfindungsgemäßen Halbleiterbauelements beziehungsweise der oben angegebenen vorteilhaften Ausführungsformen sind dem Lumineszenzkonversionselement oder einer anderen strahlungsdurchlässigen Komponente der Bauteilumhüllung zusätzlich Licht streuende Partikel, so genannte Diffusoren, zugesetzt. Hierdurch lässt sich vorteilhafterweise der Farbeindruck und die Abstrahlcharakteristik des Halbleiterbauelements weiter optimieren.

Von besonderem Vorteil ist, dass die Leuchteffizienz von weiß leuchtenden erfindungsgemäßen Halbleiterbauelementen beziehungsweise deren oben genannten Ausführungsformen mit einem im Wesentlichen auf der Basis von GaN hergestellten blau leuchtenden Halbleiterkörper vergleichbar ist mit der Leuchteffizienz einer Glühbirne. Der Grund dafür besteht darin, dass zum einen die externe Quantenausbeute derartiger Halbleiterkörper bei einigen Prozent liegt und andererseits die Lumineszenzausbeute von organischen Farbstoff-Molekülen oft bei über 90 % angesiedelt ist. Darüber hinaus zeichnet sich das erfindungsgemäße Halbleiterbauelement im Vergleich zur Glühbirne durch eine extrem lange Lebensdauer, größere Robustheit und eine kleinere Betriebsspannung aus.

Vorteilhaft ist weiterhin, dass die für das menschliche Auge wahrnehmbare Helligkeit des erfindungsgemäßen Halbleiterbauelements gegenüber einem ohne Lumineszenzkonversionselement ausgestatteten, aber sonst identischen Halbleiterbauelement deutlich erhöht werden kann, da die Augenempfindlichkeit zu höherer Wellenlänge hin zunimmt.

Darüber hinaus kann mit dem erfindungsgemäßen Prinzip vorteilhafterweise auch eine von dem Halbleiterkörper neben der sichtbaren Strahlung ausgesandte ultraviolette Strahlung in sichtbares Licht umgewandelt werden. Dadurch wird die Helligkeit des vom Halbleiterkörper ausgesandten Lichts deutlich erhöht.

Das hier vorgestellte Konzept der Lumineszenzkonversion mit blauem Licht eines Halbleiterkörpers lässt sich vorteilhafterweise auch auf mehrstufige Lumineszenzkonversionselemente erweitern, nach dem Schema ultraviolett → blau → grün → gelb → rot. Hierbei wird eine Mehrzahl von spektral selektiv emittierenden Lumineszenzkonversionselementen relativ zum Halbleiterkörper hintereinander angeordnet.

Ebenso können vorteilhafterweise mehrere unterschiedlich spektral selektiv emittierende Farbstoffmoleküle gemeinsam in einen transparenten Kunststoff eines Lumineszenzkonversionselements eingebettet sein. Hierdurch ist ein sehr breites Farbenspektrum erzeugbar.

Ein besonderer Vorteil von erfindungsgemäßen weißes Licht abstrahlenden Halbleiterbauelementen, bei denen als Lumineszenzkonversionsfarbstoff insbesondere YAG:Ce verwendet ist, besteht darin, dass dieser Leuchtstoff bei Anregung mit blauem Licht eine spektrale Verschiebung von zirka 100 nm zwischen Absorption und Emission bewirkt. Dies führt zu einer wesentlichen Reduktion der Reabsorption des vom Leuchtstoff emittierten Lichtes und damit zu einer höheren Lichtausbeute. Außerdem besitzt YAG:Ce vorteilhafterweise eine hohe thermische und photochemische (zum Beispiel UV-) Stabilität (wesentlich höher als organische Leuchtstoffe), so dass auch weiß leuchtende Dioden für Außenanwendung und/oder hohe Temperaturbereiche herstellbar sind.

YAG:Ce hat sich bislang hinsichtlich Reabsorption, Lichtausbeute, thermischer und photochemischer Stabilität und Verarbeitbarkeit als am besten geeigneter Leuchtstoff herausgestellt. Denkbar ist jedoch auch die Verwendung von anderen Ce-dotierten Phosphoren, insbesondere Ce-dotierten Granaten.

Besonders vorteilhaft lassen sich erfindungsgemäße Halbleiterbauelemente insbesondere aufgrund ihrer geringen Leistungsaufnahme in vollfarbtauglichen LED-Displays, zur Beleuchtung von Kfz-Innenräumen oder von Flugzeugkabinen sowie zur Beleuchtung von Anzeigevorrichtungen wie Kfz-Armaturen oder Flüssigkristallanzeigen verwenden.

Weitere Merkmale, Vorteile und Zweckmäßigkeiten der Erfindung ergeben sich aus der nachfolgenden Beschreibung von neun Ausführungsbeispielen in Verbindung mit den Figuren 1 bis 14. Es zeigen:
- Figur 1: eine schematische Schnittansicht eines ersten Ausführungsbeispieles eines erfindungsgemäßen Halbleiterbauelements;
- Figur 2: eine schematische Schnittansicht eines zweiten Ausführungsbeispieles eines erfindungsgemäßen Halbleiterbauelementes;
- Figur 3: eine schematische Schnittansicht durch ein drittes Ausführungsbeispiel eines erfindungsgemäße Halbleiterbauelementes;
- Figur 4: eine schematische Schnittansicht eines vierten Ausführungsbeispieles eines erfindungsgemäßen Halbleiterbauelements;
- Figur 5: eine schematische Schnittansicht eines fünften Ausführungsbeispieles eines erfindungsgemäßen Halbleiterbauelementes;
- Figur 6: eine schematische Schnittansicht eines sechsten Ausführungsbeispieles eines erfindungsgemäßen Halbleiterbauelementes;
- Figur 7: eine schematische Darstellung eines Emissionsspektrums eines blaues Licht abstrahlenden Halbleiterkörpers mit einer Schichtenfolge auf der Basis von GaN;
- Figur 8: eine schematische Darstellung der Emissionsspektren zweier erfindungsgemäßer Halbleiterbauelemente, die weißes Licht abstrahlen;
- Figur 9: eine schematische Schnittdarstellung durch einen Halbleiterkörper, der blaues Licht aussendet;
- Figur 10: eine schematische Schnittansicht eines siebten Ausführungsbeispieles eines erfindungsgemäßen Halbleiterbauelementes;
- Figur 11: eine schematische Darstellung eines Emissionsspektrums eines erfindungsgemäßen Halbleiterbauelementes, das mischfarbiges rotes Licht abstrahlt;
- Figur 12: eine schematische Darstellung der Emissionsspektren von weiteren erfindungsgemäßen Halbleiterbauelementen, die weißes Licht abstrahlen;
- Figur 13: eine schematische Schnittansicht eines achten Ausführungsbeispieles eines erfindungsgemäßen Halbleiterbauelementes und
- Figur 14: eine schematische Schnittansicht eines neunten Ausführungsbeispieles eines erfindungsgemäßen Halbleiterbauelementes.

In den verschiedenen Figuren sind gleiche beziehungsweise gleich wirkende Teile immer mit denselben Bezugszeichen bezeichnet.

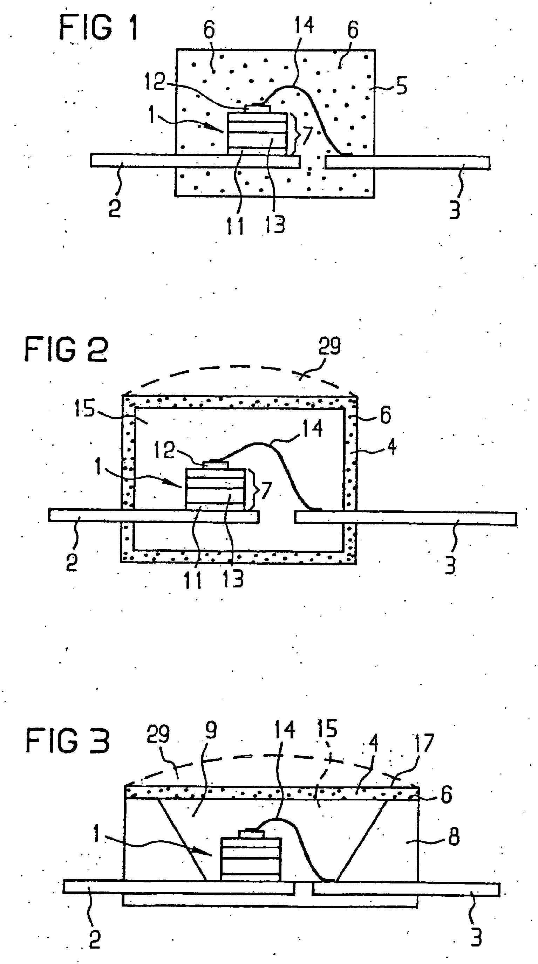

Bei dem in Figur 1 dargestellten Licht aussendenden Halbleiterbauelement weist ein Halbleiterkörper 1 einen Rückseitenkontakt 11, einen Vorderseitenkontakt 12 und eine sich aus einer Anzahl von unterschiedlichen Schichten zusammensetzende Schichtenfolge 7 auf, die im Betrieb des Halbleiterbauelements mindestens eine eine Strahlung (zum Beispiel ultraviolett, blau oder grün) aussendende aktive Zone besitzt.

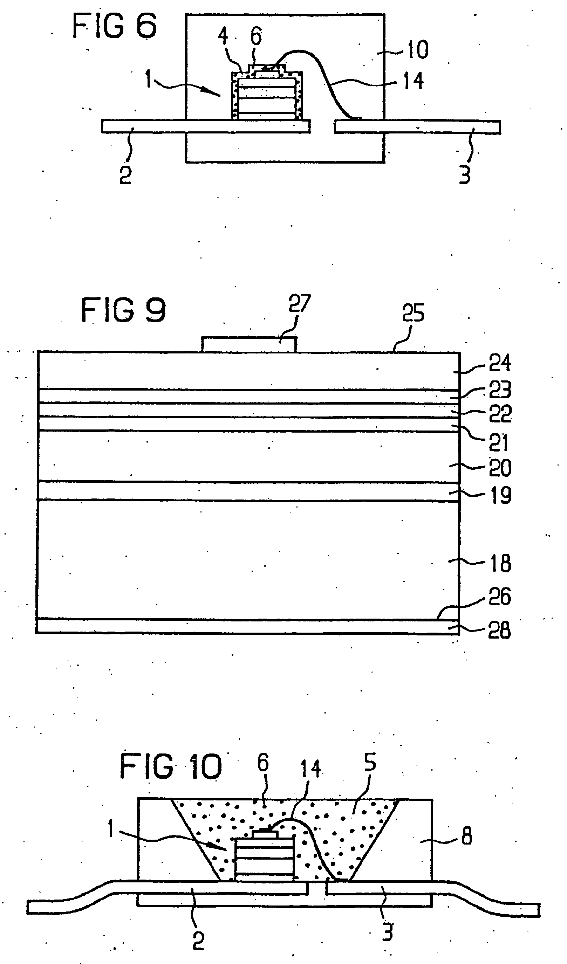

Ein Beispiel für eine geeignete Schichtenfolge 7 für dieses und für sämtliche im Folgenden beschriebenen Ausführungsbeispiele ist in Figur 9 gezeigt. Hierbei ist auf einem Substrat 18, das zum Beispiel aus SiC besteht, eine Schichtenfolge aus einer AlN- oder GaN-Schicht 19, einer n-leitenden GaN-Schicht 20, einer n-leitenden GaₓAl₁₋ₓN- oder GaₓIn₁₋ₓN-Schicht 21, einer weiteren n-leitenden GaN- oder einer GaₓIn₁₋ₓN-Schicht 22, einer p-leitenden GaₓAl₁₋ₓN- oder GaₓIn₁₋ₓN-Schicht 23 und einer p-leitenden GaN-Schicht 24 aufgebracht. Auf einer Hauptfläche 25 der p-leitenden GaN-Schicht 24 und einer Hauptfläche 26 des Substrats 18 ist jeweils eine Kontaktmetallisierung 27, 28 aufgebracht, die aus einem herkömmlich in der Opto-Halbleitertechnik für elektrische Kontakte verwendeten Werkstoff besteht.

Es kann jedoch auch jeder andere dem Fachmann für das erfindungsgemäße Halbleiterbauelement als geeignet erscheinende Halbleiterkörper verwendet werden. Dies gilt ebenso für sämtliche nachfolgend beschriebenen Ausführungsbeispiele.

Im Ausführungsbeispiel von Figur 1 ist der Halbleiterkörper 1 mittels eines elektrisch leitenden Verbindungsmittels, zum Beispiel ein metallisches Lot oder ein Klebstoff, mit seinem Rückseitenkontakt 11 auf einem ersten elektrischen Anschluss 2 befestigt. Der Vorderseitenkontakt 12 ist mittels eines Bonddrahtes 14 mit einem zweiten elektrischen Anschluss 3 verbunden.

Die freien Oberflächen des Halbleiterkörpers 1 und Teilbereiche der elektrischen Anschlüsse 2 und 3 sind unmittelbar von einer Lumineszenzkonversionsumhüllung 5 umschlossen. Diese besteht bevorzugt aus einem für transparente Leuchtdiodenumhüllungen verwendbaren transparenten Kunststoff (bevorzugt Epoxidharz oder auch Polymethylmetaacrylat), der mit Leuchtstoff 6, bevorzugt anorganischer Leuchtstoff, für weiß leuchtende Bauelemente bevorzugt Y₃Al₅O₁₂:Ce³⁺ (YAG:Ce), versetzt ist.

Das in Figur 2 dargestellte Ausführungsbeispiel eines erfindungsgemäßen Halbleiterbauelements unterscheidet sich von dem der Figur 1 dadurch, dass der Halbleiterkörper 1 und Teilbereiche der elektrischen Anschlüsse 2 und 3 anstatt von einer Lumineszenzkonversionsumhüllung von einer transparenten Umhüllung 15 umschlossen sind. Diese transparente Umhüllung 15 bewirkt keine Wellenlängenänderung der von dem Halbleiterkörper 1 ausgesandten Strahlung und besteht beispielsweise aus einem in der Leuchtdiodentechnik herkömmlich verwendeten Epoxid-, Silikon- oder Acrylatharz oder aus einem anderen geeigneten strahlungsdurchlässigen Material wie zum Beispiel anorganisches Glas.

Auf diese transparente Umhüllung 15 ist eine Lumineszenzkonversionsschicht 4 aufgebracht, die, wie in der Figur 2 dargestellt, die gesamte Oberfläche der Umhüllung 15 bedeckt. Ebenso denkbar ist, dass die Lumineszenzkonversionsschicht 4 nur einen Teilbereich dieser Oberfläche bedeckt. Die Lumineszenzkonversionsschicht 4 besteht beispielsweise wiederum aus einem transparenten Kunststoff (zum Beispiel Epoxidharz, Lack oder Polymethylmetaacrylat), der mit einem Leuchtstoff 6 versetzt ist. Auch hier eignet sich als Leuchtstoff für ein weiß leuchtendes Halbleiterbauelement bevorzugt YAG:Ce.

Dieses Ausführungsbeispiel hat den besonderen Vorteil, dass für die gesamte von dem Halbleiterkörper ausgesandte Strahlung die Weglänge durch das Lumineszenzkonversionselement näherungsweise gleich groß ist. Dies spielt insbesondere dann eine bedeutende Rolle, wenn, wie oftmals der Fall, der genaue Farbton des von dem Halbleiterbauelement abgestrahlten Lichtes von dieser Weglänge abhängt.

Zur besseren Auskopplung des Lichtes aus der Lumineszenzkonversionsschicht 4 von Figur 2 kann auf einer Seitenfläche des Bauelements eine linsenförmige Abdeckung 29 (gestrichelt eingezeichnet) vorgesehen sein, die eine Totalreflexion der Strahlung innerhalb der Lumineszenzkonversionsschicht 4 reduziert. Diese linsenförmige Abdeckung 29 kann aus transparentem Kunststoff oder Glas bestehen und auf die Lumineszenzkonversionsschicht 4 beispielsweise aufgeklebt oder direkt als Bestandteil der Lumineszenzkonversionsschicht 4 ausgebildet sein.

Bei dem in Figur 3 dargestellten Ausführungsbeispiel sind der erste und zweite elektrische Anschluss 2, 3 in ein lichtundurchlässiges, eventuell vorgefertigtes Grundgehäuse 8 mit einer Ausnehmung 9 eingebettet. Unter "vorgefertigt" ist zu verstehen, dass das Grundgehäuse 8 bereits an den Anschlüssen 2, 3 beispielsweise mittels Spritzguss fertig ausgebildet ist, bevor der Halbleiterkörper auf den Anschluss 2 montiert wird. Das Grundgehäuse 8 besteht beispielsweise aus einem lichtundurchlässigen Kunststoff und die Ausnehmung 9 ist hinsichtlich ihrer Form als Reflektor 17 für die vom Halbleiterkörper im Betrieb ausgesandte Strahlung (gegebenenfalls durch geeignete Beschichtung der Innenwände der Ausnehmung 9) ausgebildet. Solche Grundgehäuse 8 werden insbesondere bei auf Leiterplatten oberflächenmontierbaren Leuchtdioden verwendet. Sie werden vor der Montage der Halbleiterkörper auf ein die elektrischen Anschlüsse 2, 3 aufweisendes Leiterband (Leadframe) zum Beispiel mittels Spritzgießen aufgebracht.

Die Ausnehmung 9 ist von einer Lumineszenzkonversionsschicht 4, beispielsweise eine separat hergestellte und auf dem Grundgehäuse 8 befestigte Abdeckplatte 17 aus Kunststoff, abgedeckt. Als geeignete Materialien für die Lumineszenzkonversionsschicht 4 kommen wiederum die weiter oben im allgemeinen Teil der Beschreibung genannten Kunststoffe oder anorganisches Glas in Verbindung mit den dort genannten Leuchtstoffen in Frage. Die Ausnehmung 9 kann sowohl mit einem transparenten Kunststoff, mit einem anorganischen Glas oder mit Gas gefüllt als auch mit einem Vakuum versehen sein.

Wie bei dem Ausführungsbeispiel nach Figur 2 kann auch hier zur besseren Auskopplung des Lichtes aus der Lumineszenzkonversionsschicht 4 auf dieser eine linsenförmige Abdeckung 29 (gestrichelt eingezeichnet) vorgesehen sein, die eine Totalreflexion der Strahlung innerhalb der Lumineszenzkonversionsschicht 4 reduziert. Diese Abdeckung 29 kann aus transparentem Kunststoff bestehen und auf die Lumineszenzkonversionsschicht 4 beispielsweise aufgeklebt oder zusammen mit der Lumineszenzkonversionsschicht 4 einstückig ausgebildet sein.

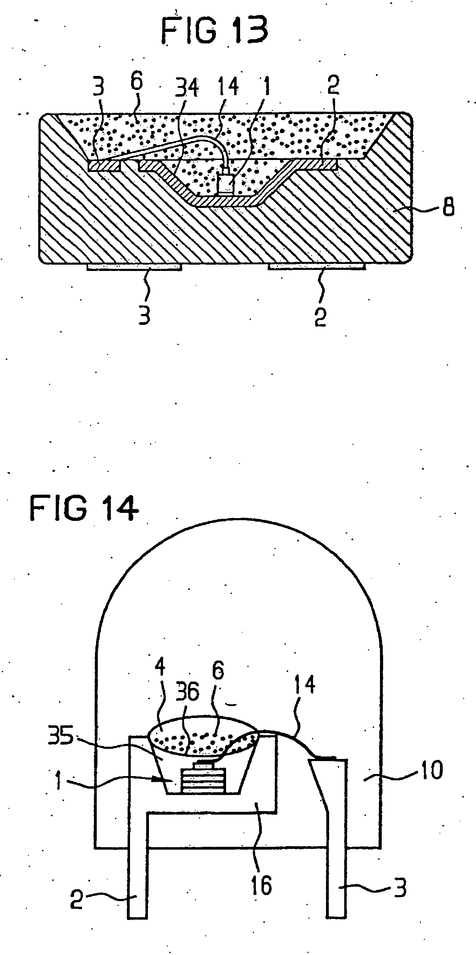

Bei einer besonders bevorzugten Ausführungsform ist die Ausnehmung 9, wie in Figur 10 gezeigt, mit einem mit Leuchtstoff versehenen Epoxidharz, das heißt mit einer Lumineszenzumhüllung 5 gefüllt, die das Lumineszenzkonversionselement bildet. Eine Abdeckplatte 17 und/oder eine linsenförmige Abdeckung 29 kann dann auch weggelassen sein. Weiterhin ist optional, wie in Figur 13 dargestellt, der erste elektrische Anschluss 2 zum Beispiel durch Prägen im Bereich des Halbleiterkörpers 1 als Reflektorwanne 34 ausgebildet, die mit einer Lumineszenzkonversionsumhüllung 5 gefüllt ist.

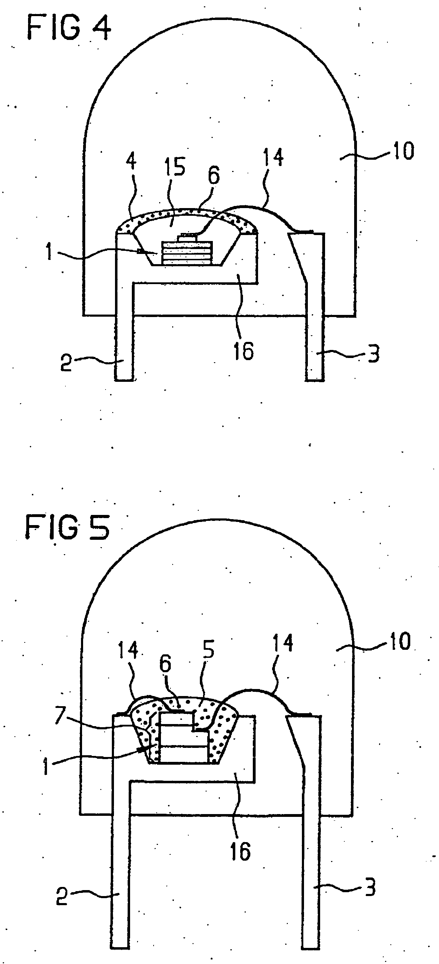

In Figur 4 ist als weiteres Ausführungsbeispiel eine so genannte Radialdiode dargestellt. Hierbei ist der Halbleiterkörper 1 in einem als Reflektor ausgebildeten Teil 16 des ersten elektrischen Anschlusses 2 beispielsweise mittels Löten oder Kleben befestigt. Derartige Gehäusebauformen sind in der Leuchtdiodentechnik bekannt und bedürfen von daher keiner näheren Erläuterung.

Bei dem Ausführungsbeispiel von Figur 4 ist der Halbleiterkörper 1 von einer transparenten Umhüllung 15 umgeben, die, wie beim zweitgenannten Ausführungsbeispiel (Figur 2), keine Wellenlängenänderung der von dem Halbleiterkörper 1 ausgesandten Strahlung bewirkt und beispielsweise aus einem herkömmlich in der Leuchtdiodentechnik verwendeten transparenten Epoxidharz oder aus organischem Glas bestehen kann.

Auf dieser transparenten Umhüllung 15 ist eine Lumineszenzkonversionsschicht 4 aufgebracht. Als Material hierfür kommen beispielsweise wiederum die im Zusammenhang mit den vorgenannten Ausführungsbeispielen angeführten Kunststoffe oder anorganisches Glas in Verbindung mit den dort genannten Farbstoffen in Frage.

Der gesamte Aufbau, bestehend aus Halbleiterkörper 1, Teilbereiche der elektrischen Anschlüsse 2, 3, transparente Umhüllung 15 und Lumineszenzkonversionsschicht 4, ist unmittelbar von einer weiteren transparenten Umhüllung 10 umschlossen, die keine Wellenlängenänderung der durch die Lumineszenzkonversionsschicht 4 hindurch getretenen Strahlung bewirkt. Sie besteht beispielsweise wiederum aus einem herkömmlich in der Leuchtdiodentechnik verwendeten transparenten Epoxidharz oder aus anorganischem Glas.

Das in Figur 5 gezeigte Ausführungsbeispiel unterscheidet sich von dem von Figur 4 im Wesentlichen dadurch, dass die freien Oberflächen des Halbleiterkörpers 1 unmittelbar von einer Lumineszenzkonversionsumhüllung 5 bedeckt sind, die wiederum von einer weiteren transparenten Umhüllung 10 umgeben ist. In Figur 5 ist weiterhin beispielhaft ein Halbleiterkörper 1 dargestellt, bei dem anstelle des Unterseitenkontaktes ein weiterer Kontakt auf der Halbleiterschichtenfolge 7 angebracht ist, der mittels eines zweiten Bonddrahtes 14 mit dem zugehörigen elektrischen Anschluss 2 oder 3 verbunden ist. Selbstverständlich sind derartige Halbleiterkörper 1 auch bei allen anderen hierin beschriebenen Ausführungsbeispielen einsetzbar. Umgekehrt ist natürlich auch bei dem Ausführungsbeispiel von Figur 5 ein Halbleiterkörper 1 gemäß den vorgenannten Ausführungsbeispielen verwendbar.

Der Vollständigkeit halber sei an dieser Stelle angemerkt, dass selbstverständlich auch bei der Bauform nach Figur 5 analog zu dem Ausführungsbeispiel nach Figur 1 eine einstückige Lumineszenzkonversionsumhüllung 5, die dann an die Stelle der Kombination aus Lumineszenzkonversionsumhüllung 5 und weiterer transparenter Umhüllung 10 tritt, verwendet sein kann.

Bei dem Ausführungsbeispiel von Figur 6 ist eine Lumineszenzkonversionsschicht 4 (mögliche Materialien wie oben angegeben) direkt auf den Halbleiterkörper 1 aufgebracht. Dieser und Teilbereiche der elektrischen Anschlüsse 2, 3 sind von einer weiteren transparenten Umhüllung 10 umschlossen, die keine Wellenlängenänderung der durch die Lumineszenzkonversionsschicht 4 hindurch getretenen Strahlung bewirkt und beispielsweise aus einem in der Leuchtdiodentechnik verwendbaren transparenten Epoxidharz oder aus Glas gefertigt ist.

Solche, mit einer Lumineszenzkonversionsschicht 4 versehenen Halbleiterkörper 1 ohne Umhüllung können natürlich vorteilhafterweise in sämtlichen aus der Leuchtdiodentechnik bekannten Gehäusebauformen (zum Beispiel SMD-Gehäuse, Radial-Gehäuse (man vergleiche Figur 5)) verwendet sein.

Bei dem in Figur 14 dargestellten Ausführungsbeispiel eines erfindungsgemäßen Halbleiterbauelements ist auf dem Halbleiterkörper 1 ein transparentes Wannenteil 35 angeordnet, das über dem Halbleiterkörper 1 eine Wanne 36 aufweist. Das Wannenteil 35 besteht beispielsweise aus transparentem Epoxidharz oder aus anorganischem Glas und ist zum Beispiel mittels Umspritzen der elektrischen Anschlüsse 2, 3 einschließlich Halbleiterkörper 1 gefertigt. In dieser Wanne 36 ist eine Lumineszenzkonversionsschicht 4 angeordnet, die zum Beispiel wiederum aus Epoxidharz oder anorganischem Glas gefertigt ist, in das Partikel 37, bestehend aus einem der oben genannten anorganischen Leuchtstoffe, eingebunden sind. Bei dieser Bauform wird vorteilhafterweise auf sehr einfache Weise sichergestellt, dass sich der Leuchtstoff während der Herstellung des Halbleiterbauelements an nicht vorgesehenen Stellen, zum Beispiel neben dem Halbleiterkörper, ansammelt. Das Wannenteil 35 kann selbstverständlicherweise auch separat hergestellt und anderweitig, zum Beispiel an einem Gehäuseteil, über dem Halbleiterkörper 1 befestigt sein.

Bei sämtlichen der oben beschriebenen Ausführungsbeispiele kann zur Optimierung des Farbeindrucks des abgestrahlten Lichts sowie zur Anpassung der Abstrahlcharakteristik das Lumineszenzkonversionselement (Lumineszenzkonversionsumhüllung 5 oder Lumineszenzkonversionsschicht 4), gegebenenfalls die transparente Umhüllung 15, und/oder gegebenenfalls die weitere transparente Umhüllung 10 Licht streuende Partikel, vorteilhafterweise so genannte Diffusoren aufweisen. Beispiele für derartige Diffusoren sind mineralische Füllstoffe, insbesondere CaF₂, TiO₂, SiO₂, CaCO₃ oder BaSO₄ oder auch organische Pigmente. Diese Materialien können auf einfache Weise den oben genannten Kunststoffen zugesetzt werden.

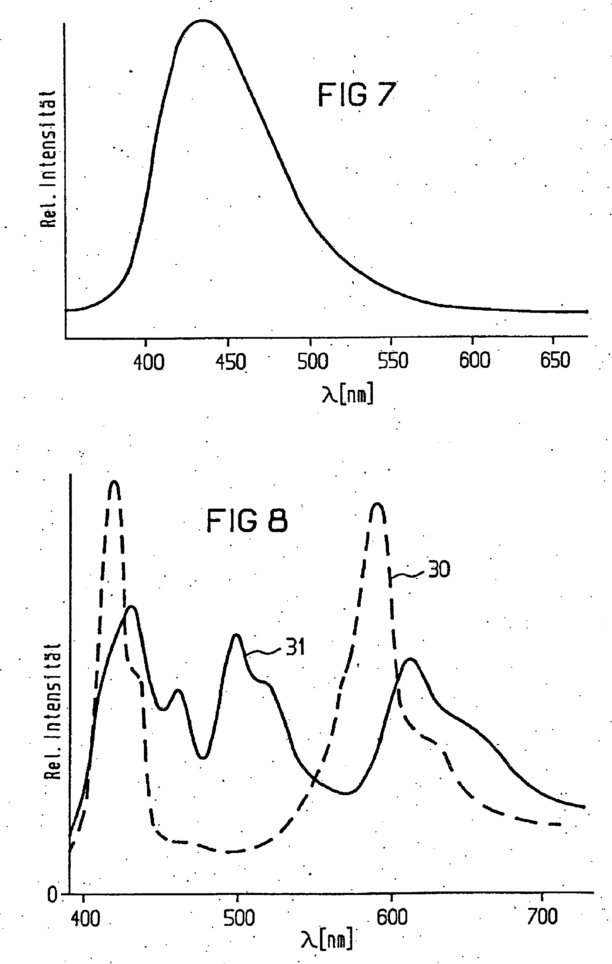

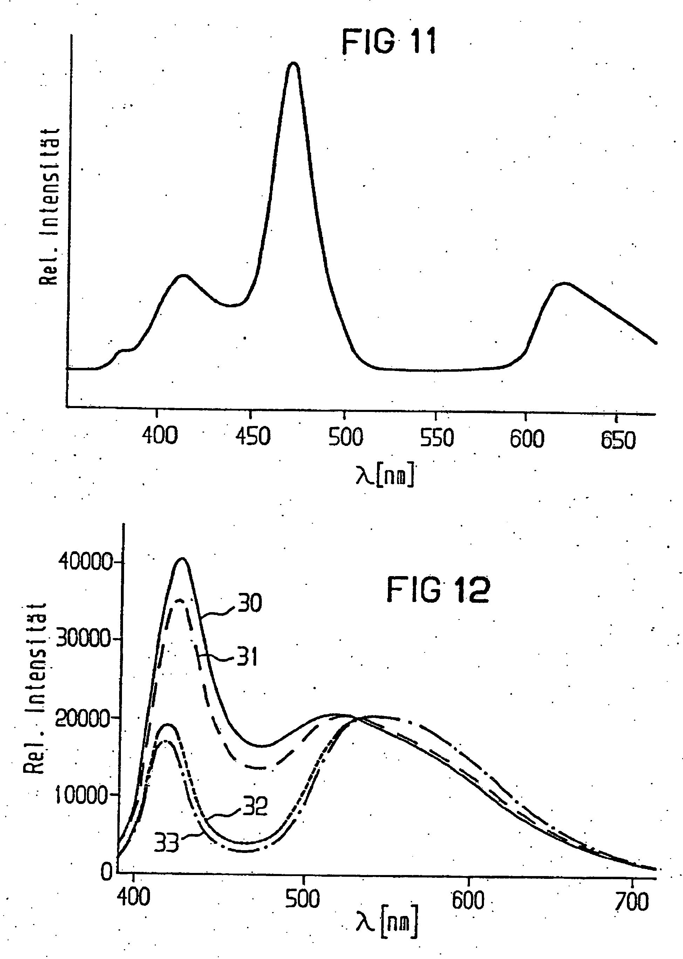

In den Figuren 7, 8 und 12 sind Emissionsspektren eines blaues Licht abstrahlenden Halbleiterkörpers (Figur 7) (Lumineszenzmaximum bei λ ∼ 430 nm) beziehungsweise von mittels eines solchen Halbleiterkörpers hergestellten weiß leuchtenden erfindungsgemäßen Halbleiterbauelementen (Figur 8 und 12) gezeigt. An der Abszisse ist jeweils die Wellenlänge λ in nm und auf der Ordinate ist jeweils eine relative Elektrolumineszenz(EL)-Intensität aufgetragen.

Von der vom Halbeiterkörper ausgesandten Strahlung nach Figur 7 wird nur ein Teil in einen längerwelligen Wellenlängenbereich konvertiert, so dass als Mischfarbe weißes Licht entsteht. Die gestrichelte Linie 30 in Figur 8 stellt ein Emissionsspektrum von einem erfindungsgemäßen Halbleiterbauelement dar, das Strahlung aus zwei komplementären Wellenlängenbereichen (Blau und Gelb) und damit insgesamt weißes Licht aussendet. Das Emissionsspektrum weist hier bei Wellenlängen zwischen zirka 400 und zirka 430 nm (Blau) und zwischen zirka 550 und zirka 580 nm (Gelb) je ein Maximum auf. Die durchgezogene Linie 31 repräsentiert das Emissionsspektrum eines erfindungsgemäßen Halbleiterbauelements, das die Farbe Weiß aus drei Wellenlängenbereichen (additives Farbtripel aus Blau, Grün und Rot) mischt. Das Emissionsspektrum weist hier beispielsweise bei den Wellenlängen von zirka 430 nm (Blau), zirka 500 nm (Grün) und zirka 615 nm (Rot) je ein Maximum auf.

Des Weiteren ist in Figur 11 ein Emissionsspektrum eines erfindungsgemäßen Halbleiterbauelements dargestellt, das mischfarbiges Licht aus blauem Licht (Maximum bei einer Wellenlänge von zirka 470 nm) und rotem Licht (Maximum bei einer Wellenlänge von zirka 620 nm) abstrahlt. Der Gesamtfarbeindruck des abgestrahlten Lichtes für das menschliche Auge ist Magenta. Das vom Halbleiterkörper abgestrahlte Emissionsspektrum entspricht hier wiederum dem von Figur 7.

Figur 12 zeigt ein weiß leuchtendes erfindungsgemäßes Halbleiterbauelement, das mit einem ein Emissions-Spektrum gemäß Figur 7 aussendenden Halbleiterkörper versehen ist und bei dem als Leuchtstoff YAG:Ce verwendet ist. Von der vom Halbeiterkörper ausgesandten Strahlung nach Figur 7 wird nur ein Teil in einen längerwelligen Wellenlängenbereich konvertiert, so dass als Mischfarbe weißes Licht entsteht. Die verschiedenartig gestrichelten Linien 30 bis 33 von Figur 8 stellen Emissionsspektren von erfindungsgemäßen Halbleiterbauelementen dar, bei denen das Lumineszenzkonversionselement, in diesem Fall eine Lumineszenzkonversionsumhüllung aus Epoxidharz, unterschiedliche YAG:Ce-Konzentrationen aufweist. Jedes Emissionsspektrum weist zwischen λ = 420 nm und = 430 nm, also im blauen Spektralbereich, und zwischen λ = 520 nm und λ = 545 nm, also im grünen Spektralbereich, jeweils ein Intensitätsmaximum auf, wobei die Emissionsbanden mit dem längerwelligen Intensitätsmaximum zu einem großen Teil im gelben Spektralbereich liegen. Das Diagramm von Figur 12 verdeutlicht, dass bei dem erfindungsgemäßen Halbleiterbauelement auf einfache Weise durch Veränderung der Leuchtstoffkonzentration im Epoxidharz der CIE-Farbort des weißen Lichtes verändert werden kann.

Weiterhin ist es möglich, anorganische Leuchtstoffe auf Basis von Ce-dotierten Granaten, Thiogallaten, Erdalkali-Sulfiden und Aluminaten direkt auf den Halbleiterkörper aufzubringen, ohne sie in Epoxidharz oder Glas zu dispergieren.

Ein weiterer besonderer Vorteil der oben genannten anorganischen Leuchtstoffe ergibt sich daraus, dass die Leuchtstoffkonzentration zum Beispiel im Epoxidharz nicht wie bei organischen Farbstoffen durch die Löslichkeit begrenzt wird. Dadurch sind keine großen Dicken von Lumineszenzkonversionselementen nötig.

Die Erläuterung des erfindungsgemäßen Halbleiterbauelements anhand der oben beschriebenen Ausführungsbeispiele ist natürlich nicht als Beschränkung der Erfindung auf diese zu betrachten. Als Halbleiterkörper, wie beispielsweise Leuchtdioden-Chips oder Laserdioden-Chips, ist beispielsweise auch eine Polymer-LED zu verstehen, die ein entsprechendes Strahlungsspektrum aussendet.

## Patentansprüche

1. Lichtabstrahlendes Halbleiterbauelement, insbesondere Leuchtdiode, mit einem Lumineszenzkonversionselement und einem Halbleiterkörper (1), der eine Halbleiterschichtenfolge aufweist, die im Betrieb des Halbleiterbauelements elektromagnetische Strahlung eines ersten Wellenlängenbereichs aussendet, der Strahlung aus dem ultravioletten, blauen und/oder grünen Spektralbereich aufweist mit einem Intensitätsmaximum bei einer Wellenlänge λ ≤ 520 nm, **dadurch gekennzeichnet, dass**
das Lumineszenzkonversionselement mehrere Schichten mit unterschiedlichen Wellenlängenkonversionseigenschaften aufweist, und
das Lumineszenzkonversionselement im Betrieb des Halbleiterbauelements eine oder mehrere aus dem ersten Wellenlängenbereich stammende erste spektrale Teilbereiche der von der Halbleiterschichtenfolge emittierten Strahlung in mehrere zweite Wellenlängenbereiche umwandelt.

2. Lichtabstrahlendes Halbleiterbauelement nach dem vorherigen Anspruch, bei dem der Halbleiterkörper (1) in der Ausnehmung (9) eines Gehäuses (8) angeordnet ist, die mit einem transparenten Material gefüllt ist, das lumineszenzkonvertierend ausgebildet ist, und bei dem die Ausnehmung (9) mit einem ein Lumineszenzkonversionselement aufweisenden Abdeckelement versehen ist.

3. Lichtabstrählendes Halbleiterbauelement nach einem der obigen Ansprüche, bei dem das Lumineszenzkonversionselement und/oder das transparente Material eines der folgenden Materialien aufweist, in das ein Leuchtstoff eingebettet ist: Epoxidharz, Silikonmaterial, Acrylatharz.

4. Lichtabstrahlendes Halbleiterbauelement nach einem der Ansprüche 1 bis 2, bei dem das Lumineszenzkonversionselement und/oder das transparente Material ein anorganisches Glas aufweist, in das ein anorganischer Leuchtstoff eingebettet ist.

5. Lichtabstrahlendes Halbleiterbauelement nach dem vorherigen Anspruch, bei dem der anorganische Leuchtstoff aus der folgenden Gruppe gewählt ist: mit Seltenen Erden dotierten Granate, mit Seltenen Erden dotierte Erdalkali-Sulfide, mit Seltenen Erden dotierten Thiogallate, mit Seltenen Erden dotierten Aluminate, mit Seltenen Erden dotierten Orthosilikate.

6. Lichtabstrahlendes Halbleiterbauelement nach einem der obigen Ansprüche, das weißes Licht aussendet.

7. Lichtabstrahlendes Halbleiterbauelement nach einem der obigen Ansprüche, bei dem das Lumineszenzkonversionselement und/oder das transparente Material lichtstreuende Partikel () aufweist.

8. Lichtabstrahlendes Halbleiterbauelement nach einem der obigen Ansprüche, wobei die von dem Halbleiterkörper (1) ausgesandte Strahlung bei einer Wellenlängen zwischen 420 nm und 460 nm ein relatives Intensitätsmaximum aufweist.

9. Lichtabstrahlendes Halbleiterbauelement nach einem der obigen Ansprüche, bei dem der Halbleiterkörper (1) im Betrieb des Halbleiterbauelements ultraviolette Strahlung aussendet und das Lumineszenzkonversionselement zumindest einen Teil dieser ultravioletten Strahlung in sichtbares Licht umwandelt.

10. Lichtabstrahlendes Halbleiterbauelement nach einem der obigen Ansprüche, bei dem eine Richtcharakteristik der von der Halbleiterschichtenfolge abgestrahlten elektromagnetischen Strahlung durch anorganische Leuchtstoffpartikel und/oder zusätzliche lichtstreuende Partikel abgeschwächt ist, so dass die Farbhomogenität eines von dem Halbleiterbauelement ausgesandten mischfarbigen Lichts verbessert ist.

11. Lichtabstrahlendes Halbleiterbauelement nach einem der obigen Ansprüche, bei dem das Lumineszenzkonversionselement Teil eines Vergusses des Halbleiterkörpers (1) ist.

12. Beleuchtungseinrichtung zur Beleuchtung einer Anzeigevorrichtung, insbesondere einer Flüssigkristallanzeige, mit einem lichtabstrahlenden Halbleiterbauelement gemäß einem der Ansprüche 1 bis 11.

## Claims

1. Light-emitting semiconductor component, in particular light-emitting diode, comprising a luminescence conversion element and a semiconductor body (1), which has a semiconductor layer sequence that emits electromagnetic radiation in a first wavelength range during the operation of the semiconductor component, said first wavelength range having radiation from the ultraviolet, blue and/or green spectral range, with an intensity maximum at a wavelength λ ≤ 520 nm, **characterized in that**
the luminescence conversion element has a plurality of layers having different wavelength conversion properties, and
during the operation of the semiconductor component the luminescence conversion element converts one or a plurality of first spectral sub ranges - originating from the first wavelength range - of the radiation emitted by the semiconductor layer sequence into a plurality of second wavelength ranges.

2. Light-emitting semiconductor component according to the preceding claim, wherein the semiconductor body (1) is arranged in the recess (9) of a housing (8), said recess being filled with a transparent material embodied in a luminescence-converting fashion, and wherein the recess (9) is provided with a covering element comprising a luminescence conversion element.

3. Light-emitting semiconductor component according to either of the preceding claims, wherein the luminescence conversion element and/or the transparent material comprise(s) one of the following materials into which a phosphor is embedded: epoxy resin, silicone material, acrylate resin.

4. Light-emitting semiconductor component according to either of Claims 1 and 2, wherein the luminescence conversion element and/or the transparent material comprise(s) an inorganic glass into which an inorganic phosphor is embedded.

5. Light-emitting semiconductor component according to the preceding claim, wherein the inorganic phosphor is chosen from the following group: garnets doped with rare earths, alkaline earth metal sulphides doped with rare earths, thiogalates doped with rare earths, aluminates doped with rare earths, orthosilicates doped with rare earths.

6. Light-emitting semiconductor component according to any of the preceding claims, which emits white light.

7. Light-emitting semiconductor component according to any of the preceding claims, wherein the luminescence conversion element and/or the transparent material comprise(s) light-scattering particles.

8. Light-emitting semiconductor component according to any of the preceding claims, wherein the radiation emitted by the semiconductor body (1) has a relative intensity maximum at a wavelength of between 420 nm and 460 nm.

9. Light-emitting semiconductor component according to any of the preceding claims, wherein, during the operation of the semiconductor component, the semiconductor body (1) emits ultraviolet radiation and the luminescence conversion element converts at least part of said ultraviolet radiation into visible light.

10. Light-emitting semiconductor component according to any of the preceding claims, wherein a directional characteristic of the electromagnetic radiation emitted by the semiconductor layer sequence is attenuated by inorganic phosphor particles and/or additional light-scattering particles, such that the colour homogeneity of a mixed-coloured light emitted by the semiconductor component is improved.

11. Light-emitting semiconductor component according to any of the preceding claims, wherein the luminescence conversion element is part of a potting of the semiconductor body (1).

12. Illumination device for illuminating a display device, in particular a liquid crystal display, comprising a light-emitting semiconductor component according to any of Claims 1 to 11.

## Revendications

1. Composant semi-conducteur luminescent, en particulier diode électroluminescente, avec un élément convertisseur de luminescence et un corps semi-conducteur (1) qui présente une succession de couches semi-conductrices, qui émet, pendant le fonctionnement du composant semi-conducteur, un rayonnement électromagnétique d'une première plage de longueurs d'onde qui présente un rayonnement du domaine spectral ultraviolet, bleu et/ou vert avec une intensité maximale pour une longueur d'onde λ ≤ 520 nm, **caractérisé en ce que** l'élément convertisseur de luminescence présente plusieurs couches avec différentes propriétés de conversion de longueur d'onde, et l'élément convertisseur de luminescence convertit, pendant le fonctionnement du composant semi-conducteur, une ou plusieurs premières plages spectrales partielles du rayonnement émis par la succession de couches semi-conductrices et provenant de la première plage de longueurs d'onde en plusieurs deuxièmes plages de longueurs d'onde.

2. Composant semi-conducteur luminescent selon la revendication précédente, dans lequel le corps semi-conducteur (1) est disposé dans le creux (9) d'un boîtier (8), qui est rempli d'un matériau transparent, qui est un matériau convertisseur de luminescence, et dans lequel le creux (9) est muni d'un élément de couverture présentant un élément convertisseur de luminescence.

3. Composant semi-conducteur luminescent selon l'une quelconque des revendications précédentes, dans lequel l'élément convertisseur de luminescence et/ou le matériau transparent présente un des matériaux suivants, dans lequel une substance luminescente est incorporée: résine époxy, matériau de silicone, résine acrylate.

4. Composant semi-conducteur luminescent selon l'une quelconque des revendications 1 à 2, dans lequel l'élément convertisseur de luminescence et/ou le matériau transparent comprend un verre minéral, dans lequel une substance luminescente minérale est incorporée.

5. Composant semi-conducteur luminescent selon la revendication précédente, dans lequel la substance luminescente minérale est choisie dans le groupe suivant: des grenats dopés aux terres rares, des sulfures alcalino-terreux dopés aux terres rares, des thiogallates dopés aux terres rares, des aluminates dopés aux terres rares, des orthosilicates dopés aux terres rares.

6. Composant semi-conducteur luminescent selon l'une quelconque des revendications précédentes, qui émet une lumière blanche.

7. Composant semi-conducteur luminescent selon l'une quelconque des revendications précédentes, dans lequel l'élément convertisseur de luminescence et/ou le matériau transparent comprend des particules dispersant la lumière.

8. Composant semi-conducteur luminescent selon l'une quelconque des revendications précédentes, dans lequel le rayonnement émis par le corps semi-conducteur (1) présente une intensité maximale relative pour une longueur d'onde entre 420 nm et 460 nm.

9. Composant semi-conducteur luminescent selon l'une quelconque des revendications précédentes, dans lequel le corps semi-conducteur (1) émet un rayonnement ultraviolet pendant le fonctionnement du composant semi-conducteur et l'élément convertisseur de luminescence convertit au moins une partie de ce rayonnement ultraviolet en lumière visible.

10. Composant semi-conducteur luminescent selon l'une quelconque des revendications précédentes, dans lequel une caractéristique directionnelle du rayonnement électromagnétique émis par la succession de couches semi-conductrices est affaiblie par des particules luminescentes minérales et/ou des particules dispersant la lumière supplémentaires, de telle manière que l'homogénéité chromatique d'une lumière de couleur mélangée émise par le composant semi-conducteur soit améliorée.

11. Composant semi-conducteur luminescent selon l'une quelconque des revendications précédentes, dans lequel l'élément convertisseur de luminescence fait partie d'un surmoulage du corps semi-conducteur (1).

12. Dispositif d'éclairage pour l'éclairage d'un dispositif d'affichage, en particulier d'un affichage à cristaux liquides, avec un composant semi-conducteur luminescent selon l'une quelconque des revendications 1 à 11.
